(19) Europäisches Patentamt
European Patent Office
Office européen des brevets

(11) **EP 4 772 910 A1**

(12) **EUROPEAN PATENT APPLICATION**
published in accordance with Art. 153(4) EPC

(43) Date of publication:
**08.07.2026 Bulletin 2026/28**

(21) Application number: **25818928.1**

(22) Date of filing: **15.05.2025**

(51) International Patent Classification (IPC):
**G01S 19/23** (2010.01)    **H01Q 1/27** (2006.01)

(52) Cooperative Patent Classification (CPC):
**G01R 29/10; G01S 19/23; G01S 19/35; H01Q 1/27**

(86) International application number:
**PCT/CN2025/095242**

(87) International publication number:
**WO 2025/251870 (11.12.2025 Gazette 2025/50)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.06.2024 CN 202410737618**

(71) Applicant: **Honor Device Co., Ltd.**
**Shenzhen, Guangdong 518040 (CN)**

(72) Inventors:
• **LIU, Dongping**
  **Shenzhen, Guangdong 518040 (CN)**
• **JIANG, Cheng**
  **Shenzhen, Guangdong 518040 (CN)**
• **BAI, Shuai**
  **Shenzhen, Guangdong 518040 (CN)**
• **YE, Weiyu**
  **Shenzhen, Guangdong 518040 (CN)**

(74) Representative: **Henselmann, Alexander Gerhard**
**Mitscherlich PartmbB**
**Karlstraße 7**
**80333 München (DE)**

(54) **METHOD FOR PROCESSING DATA AND ELECTRONIC DEVICE**

(57) Embodiments of this application are applicable to the field of antenna technologies, and provide a data processing method and an electronic device. First channel data is obtained, and a simulated antenna pattern is obtained. Then, simulated received data is obtained based on the first channel data and the simulated antenna pattern. The first channel data is data simulating a state of a channel between a first electronic device and a second electronic device, the simulated antenna pattern is pattern data simulating an antenna in the first electronic device, the simulated received data is data simulating a second positioning signal, the second positioning signal is a signal that is obtained when a first positioning signal sent by the second electronic device is received by the antenna in the first electronic device, and the second positioning signal is used for determining location information of the first electronic device. In other words, the simulated received data obtained through simulation in embodiments of this application implements evaluation of the impact of antenna parameters and GNSS specifications on accuracy of satellite positioning signals.

Obtain first channel data, where the first channel data is data simulating a state of a channel between a first electronic device and a second electronic device, the first electronic device includes a receiving device that receives a satellite positioning signal, and the second electronic device includes a satellite — S301

Obtain a simulated antenna pattern, where the simulated antenna pattern is pattern data simulating an antenna in the first electronic device, the simulated antenna pattern includes a first sub-vector and a second sub-vector, the first sub-vector includes a first left-hand circularly polarized vector, and the second sub-vector includes a first right-hand circularly polarized vector — S302

Obtain simulated received data based on the first channel data and the simulated antenna pattern, where the simulated received data is data simulating a second positioning signal, the second positioning signal is a signal obtained when a first positioning signal sent by the second electronic device is received by the antenna in the first electronic device, and the second positioning signal is used for determining location information of the first electronic device — S303

FIG. 9

## Description

This application claims priority to Chinese Patent Application No. 202410737618.X, filed with the China National Intellectual Property Administration on June 6, 2024 and entitled "DATA PROCESSING METHOD AND ELECTRONIC DEVICE", which is incorporated herein by reference in its entirety.

## TECHNICAL FIELD

This application relates to the field of antenna technologies, and more specifically, to a data processing method and an electronic device.

## BACKGROUND

With development of positioning technologies, some portable electronic devices may also receive satellite positioning signals, and perform positioning based on the satellite positioning signals.

For example, an antenna disposed in a smart watch may receive a satellite positioning signal sent by a satellite, and then the smart watch processes the satellite positioning signal to obtain location information of the smart watch through calculation, so as to implement a satellite positioning function. However, during the antenna design phase of the smart watch, the impact of antenna parameters and (Global Navigation Satellite System) GNSS specifications on satellite positioning accuracy cannot be effectively evaluated.

Based on this, how to evaluate the impact of antenna parameters on satellite positioning accuracy during the antenna design phase of electronic devices has become an urgent problem to be solved.

## SUMMARY

This application provides a data processing method, which can evaluate impact of an antenna parameter on satellite positioning accuracy in an antenna design phase of an electronic device.

According to a first aspect, a data processing method is provided, including:

obtaining first channel data, where the first channel data is data simulating a state of a channel between a first electronic device and a second electronic device, the first electronic device includes a receiving device that receives a satellite positioning signal, and the second electronic device includes a satellite;

obtaining a simulated antenna pattern, where the simulated antenna pattern is pattern data simulating an antenna in the first electronic device, the simulated antenna pattern includes a first sub-vector and a second sub-vector, the first sub-vector includes a first left-hand circularly polarized vector, and the second sub-vector includes a first right-hand circularly polarized vector; and

obtaining simulated received data based on the first channel data and the simulated antenna pattern, where the simulated received data is data simulating a second positioning signal, the second positioning signal is a signal obtained when a first positioning signal sent by the second electronic device is received by the antenna in the first electronic device, and the second positioning signal is used for determining location information of the first electronic device.

According to the data processing method provided in this embodiment of this application, the first channel data is obtained, the simulated antenna pattern is obtained, and then the simulated received data is obtained based on the first channel data and the simulated antenna pattern. The first channel data is data simulating the state of the channel between the first electronic device and the second electronic device. The first electronic device includes a receiving device that receives a satellite positioning signal. The second electronic device includes a satellite. The simulated antenna pattern is pattern data simulating an antenna in the first electronic device. The simulated antenna pattern includes a first sub-vector and a second sub-vector. The first sub-vector includes a first left-hand circularly polarized vector, and the second sub-vector includes a first right-hand circularly polarized vector. The simulated received data is data simulating the second positioning signal. The second positioning signal is a signal obtained when the first positioning signal sent by the second electronic device is received by the antenna in the first electronic device, and the second positioning signal is used for determining the location information of the first electronic device. In other words, in this embodiment of this application, simulation of the second positioning signal received by the antenna in the first electronic device can be implemented by using the simulated received data obtained based on the first channel data and the simulated antenna pattern. That is, simulation of impact of an antenna parameter of the first electronic device on a received satellite positioning signal is implemented, so that accuracy of the satellite positioning signal can be evaluated based on the simulated received data obtained through simulation. Further, in a conventional method, an antenna pattern used for simulation is generally a linearly polarized antenna pattern, which is relatively different from a circularly polarized antenna pattern in an actual use process. In this embodiment of this application, the simulated antenna pattern used to determine the simulated received data is a circularly polarized antenna pattern that includes a first sub-vector and a second sub-vector, and is closer to the actually used antenna pattern. Therefore, the simulated received data obtained based on the first channel data and the simulated antenna pattern is closer to actual received data, thereby improving accuracy of the second positioning signal simulated by using the simulated received data.

With reference to the first aspect, in some embodiments of the first aspect, the obtaining the simulated antenna pattern includes: obtaining the simulated antenna pattern, including: obtaining posture information of the first electronic device at a current moment; obtaining an initial antenna pattern of the first electronic device; and correcting the initial antenna pattern based on the posture information to obtain the simulated antenna pattern.

With reference to the first aspect, in some embodiments of the first aspect, the correcting the initial antenna pattern based on the posture information to obtain the simulated antenna pattern includes: rotating the initial antenna pattern based on the posture information to obtain a rotated antenna pattern; and performing vector orthogonal decomposition on the rotated antenna pattern to obtain the simulated antenna pattern.

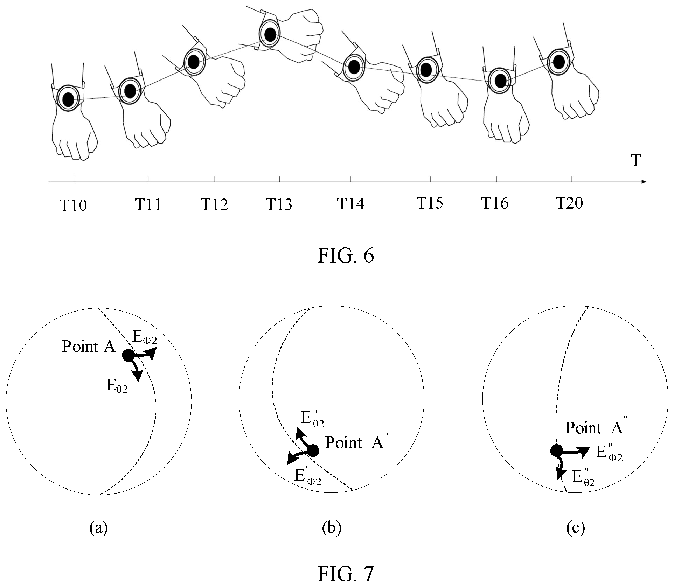

For example, the initial antenna pattern may be shown in (a) in FIG. 7. The rotated antenna pattern may be shown in (b) in FIG. 7. The simulated antenna pattern may be shown in (c) in FIG. 7.

According to the data processing method provided in this embodiment of this application, in a process of obtaining the simulated received data by using the first channel data and the simulated antenna pattern, the simulated antenna pattern is obtained by correcting the initial antenna pattern by using the posture information of the electronic device to obtain a rotated antenna pattern, and correcting a direction of a vector of the rotated antenna pattern through orthogonal vector decomposition, so that the finally obtained simulated antenna pattern can be closer to an antenna pattern of the receiving device in an actual use process, and the direction of the vector is the same as the initial antenna pattern. In this way, the simulated received data obtained based on the first channel data and the simulated antenna pattern is more accurate, thereby improving accuracy of an actual positioning signal obtained based on the simulated received data.

With reference to the first aspect, in some embodiments of the first aspect, the posture information includes azimuth angle information, the initial antenna pattern includes N sub-initial antenna patterns, the N sub-initial antenna patterns are N antenna patterns obtained based on different postures of the first electronic device, the rotated antenna pattern includes N sub-rotated antenna patterns, the N sub-initial antenna patterns are in one-to-one correspondence with the N sub-rotated antenna patterns, and the rotating the initial antenna pattern based on the posture information to obtain the rotated antenna pattern includes: rotating each of the N sub-initial antenna patterns based on the azimuth angle information to obtain the N corresponding sub-rotated antenna patterns.

According to the data processing method provided in this embodiment of this application, the first channel data is obtained, the posture information of the smart bracelet is obtained, and then the corresponding initial sub-antenna pattern is determined based on the posture information of the smart bracelet. Then, the initial sub-antenna pattern is rotated to obtain the corresponding rotated sub-antenna pattern, and vector orthogonal decomposition is performed on the rotated sub-antenna pattern to obtain the simulated antenna pattern. Finally, the simulated received data is obtained based on the first positioning data and the simulated antenna pattern. The initial antenna pattern includes N initial sub-antenna patterns, and each initial sub-antenna pattern corresponds to posture information of the smart bracelet. Because each initial sub-antenna pattern corresponds to posture information of the smart bracelet, roll angle information and pitch angle information of an antenna corresponding to different initial sub-antenna patterns are different. This is equivalent to the initial sub-antenna pattern being an antenna pattern that has been adjusted based on the roll angle information and the pitch angle information of the antenna. Therefore, when the initial sub-antenna pattern is being rotated based on the posture information, the initial sub-antenna pattern may be rotated based on only the azimuth angle information. Compared with rotating the initial sub-antenna pattern based on the azimuth angle information, the pitch angle information, and the roll angle information, this can improve efficiency of rotating the initial sub-antenna pattern, thereby improving efficiency of determining the simulated received data based on the simulated antenna pattern and the first positioning data.

With reference to the first aspect, in some embodiments of the first aspect, the posture information includes azimuth angle information, pitch angle information, and roll angle information, and the rotating the initial antenna pattern based on the posture information to obtain the rotated antenna pattern includes: rotating the initial antenna pattern based on the azimuth angle information, the pitch angle information, and the roll angle information, to obtain the rotated antenna pattern.

With reference to the first aspect, in some embodiments of the first aspect, the initial antenna pattern includes a second left-hand circularly polarized vector and a second right-hand circularly polarized vector, a direction of the second left-hand circularly polarized vector is the same as a direction of the first left-hand circularly polarized vector, and a direction of the second right-hand circularly polarized vector is the same as a direction of the first right-hand circularly polarized vector.

With reference to the first aspect, in some embodiments of the first aspect, the obtaining the first channel data includes: obtaining elevation information and latitude and longitude information of the first electronic device at a current moment; and obtaining the first channel data based on the elevation information and the latitude and longitude information.

With reference to the first aspect, in some embodiments of the first aspect, the first channel data includes one piece of simulated direct-path data and N pieces of simulated multipath data. A quantity of first sub-vectors is N+1, a quantity of second sub-vectors is N+1, the simulated direct-path data is corresponding to one first sub-vector and one second sub-vector, and the N pieces of simulated multipath data are respectively in one-to-one correspondence with the N first sub-vectors and the N second sub-vectors.

For example, one piece of simulated direct-path data and N pieces of simulated multipath data may be shown in Table 5.

Any one piece of data of the simulated direct-path data and the N pieces of simulated multipath data may be represented by using Formula (1). The formula (1) includes:

$$\overrightarrow{E_{\theta 1}} A_{\theta 1} e^{j\theta 1} + \overrightarrow{E_{\varphi 1}} A_{\varphi 1} e^{j\varphi 1} \qquad \qquad \text{Formula (1).}$$

Here, $\overrightarrow{E_{\theta 1}} A_{\theta 1} e^{j\theta 1}$ may represent the first left-hand circularly polarized vector, and $\overrightarrow{E_{\varphi 1}} A_{\varphi 1} e^{j\varphi 1}$ may represent the second right-hand circularly polarized vector.

With reference to the first aspect, in some embodiments of the first aspect, the first electronic device is a smart bracelet.

According to a second aspect, a data processing apparatus is provided, including a unit configured to perform any one of the methods in the first aspect. The apparatus may be a server, may be a terminal device, or may be a chip in a terminal device. The apparatus may include an input unit and a processing unit.

When the apparatus is a terminal device, the processing unit may be a processor, and the input unit may be a communication interface. The terminal device may further include a memory, and the memory is configured to store a computer program code. When the processor executes the computer program code stored in the memory, the terminal device is enabled to perform any method in the first aspect.

When the apparatus is a chip in a terminal device, the processing unit may be a processing unit inside the chip, and the input unit may be an output interface, a pin, a circuit, or the like. The chip may further include a memory. The memory may be a memory (for example, a register or a cache) in the chip, or may be a memory (for example, a read-only memory or a random access memory) that is located outside the chip. The memory is configured to store a computer program code. When the processor executes the computer program code that is stored in the memory, the chip is enabled to perform any method in the first aspect.

In a possible implementation, the memory is configured to store a computer program code; and the processor executes the computer program code stored in the memory. When the computer program code stored in the memory is executed, the processor is configured to perform: obtaining first channel data, where the first channel data is data simulating a state of a channel between a first electronic device and a second electronic device, the first electronic device includes a receiving device that receives a satellite positioning signal, and the second electronic device includes a satellite; obtaining a simulated antenna pattern, where the simulated antenna pattern is pattern data simulating an antenna in the first electronic device, the simulated antenna pattern includes a first sub-vector and a second sub-vector, the first sub-vector includes a first left-hand circularly polarized vector, and the second sub-vector includes a first right-hand circularly polarized vector; and obtaining simulated received data based on the first channel data and the simulated antenna pattern, where the simulated received data is data simulating a second positioning signal, the second positioning signal is a signal that is obtained when a first positioning signal sent by the second electronic device is received by the antenna in the first electronic device, and the second positioning signal is used for determining location information of the first electronic device.

According to a third aspect, a computer-readable storage medium is provided. The computer-readable storage medium stores a computer program code, and when the computer program code is run by a data processing apparatus, the data processing apparatus is enabled to perform any data processing method in the first aspect.

According to a fourth aspect, a computer program product is provided. The computer program product includes a computer program code, and when the computer program code is run by a data processing apparatus, the data processing apparatus is enabled to perform any method in the first aspect.

According to the data processing method and the electronic device provided in embodiments of this application, the first channel data is obtained, and the simulated antenna pattern is obtained; and then the simulated received data is obtained based on the first channel data and the simulated antenna pattern. The first channel data is data simulating the state of the channel between the first electronic device and the second electronic device. The first electronic device includes a receiving device that receives a satellite positioning signal. The second electronic device includes a satellite. The simulated antenna pattern is pattern data simulating the antenna in the first electronic device. The simulated antenna pattern includes the first sub-vector and the second sub-vector. The first sub-vector includes a first left-hand circularly polarized vector, and the second sub-vector includes a first right-hand circularly polarized vector. The simulated received data is data simulating the second positioning signal, the second positioning signal is a signal that is obtained when the first positioning signal sent by the second electronic device is received by the antenna in the first electronic device, and the second positioning signal is used for determining location information of the first electronic device. In other words, the embodiments of this application can simulate the second positioning signal received by the antenna in the first electronic device by using the simulated received data obtained based on the first channel data and the simulated antenna pattern, that is, simulate the impact of the antenna parameters of the first electronic device on the received satellite positioning signal. Therefore, the accuracy of the satellite positioning signal can be evaluated based on the simulated received data obtained through simulation. Further, in a conventional method, an antenna pattern used for simulation is usually a linearly polarized antenna pattern, which differs significantly from a circularly polarized antenna pattern used in actual use. In the embodiments of this application, the simulated antenna pattern used to determine the simulated received data is a circularly polarized antenna pattern including a first sub-vector and a second sub-vector, which is closer to an actually used antenna pattern. Therefore, the simulated received data obtained based on the first channel data and the simulated antenna pattern is more closely to actually received data, thereby improving the accuracy of the second positioning signal simulated by using the simulated received data.

## BRIEF DESCRIPTION OF DRAWINGS

FIG. 1 is a schematic diagram of an azimuth angle, a roll angle, and a pitch angle;
FIG. 2 is a schematic diagram of a direct-path signal and a multipath signal;
FIG. 3 is a schematic diagram of a hardware system of an electronic device applicable to this application;
FIG. 4 is a schematic diagram of an application scenario of a data processing method according to an embodiment of this application;
FIG. 5 is a schematic flowchart of a data processing method according to an embodiment of this application;
FIG. 6 is a schematic diagram of an arm swing action according to an embodiment of this application;
FIG. 7 is a schematic diagram of antenna pattern conversion according to an embodiment of this application;
FIG. 8 is a schematic flowchart of another data processing method according to an embodiment of this application;
FIG. 9 is a schematic flowchart of another data processing method according to an embodiment of this application;
FIG. 10 is a schematic diagram of a data processing apparatus according to this application; and
FIG. 11 is a schematic diagram of an electronic device for data processing according to this application.

## DESCRIPTION OF EMBODIMENTS

The following describes technical solutions in embodiments of this application with reference to the accompanying drawings in the embodiments of this application. In the descriptions of the embodiments of this application, unless otherwise specified, "/" represents "or". For example, A/B may represent A or B. In this specification, "and/or" is merely an association relationship for describing associated objects, and represents that three relationships may exist. For example, A and/or B may represent the following three cases: Only A exists, both A and B exist, and only B exists. In addition, in the descriptions of the embodiments of this application, "a plurality of" means two or more.

The following terms "first", "second", and "third" are merely used for description, and cannot be understood as an indication or implication of relative importance or an implicit indication of a quantity of indicated technical features. Therefore, a feature defined with "first", "second", or "third" may explicitly or implicitly include one or more such features.

For ease of understanding, example descriptions of some concepts related to the embodiments of this application are provided for reference.

1. Roll angle.

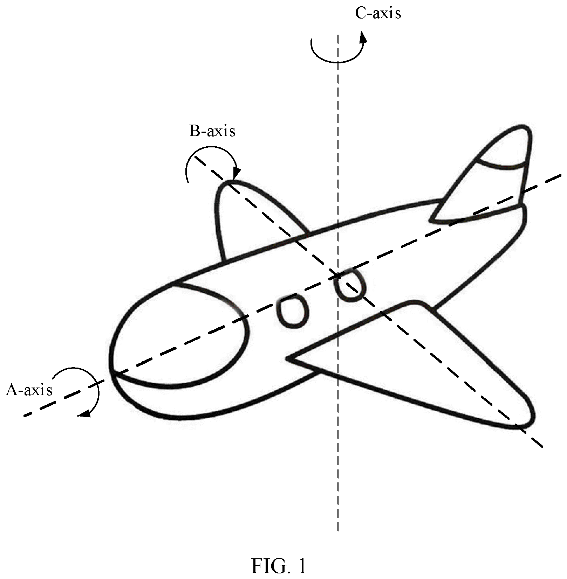

The roll angle shown in embodiments of this application may be an angle at which a device that receives a satellite positioning signal rotates along a longitudinal axis. For example, as shown in FIG. 1, an antenna carried on an aircraft may receive a positioning signal sent by a satellite, and an A-axis refers to a line connecting the apex of the head and the apex of the tail of the aircraft, and is a longitudinal axis of the aircraft. An angle at which the aircraft rotates along the A-axis is a roll angle.

2. Pitch angle.

The pitch angle shown in embodiments of this application may be an angle at which a device that receives a satellite positioning signal rotates along a lateral axis. For example, as shown in FIG. 1, an antenna carried on an aircraft may receive a positioning signal sent by a satellite. The B-axis refers to a line connecting the apexes of the two wings of the aircraft, and is the lateral axis of the aircraft. An angle at which the aircraft rotates along the B-axis is a pitch angle.

3. Azimuth angle.

The azimuth angle shown in embodiments of this application may be an angle at which a device that receives a satellite positioning signal rotates along a vertical axis. For example, as shown in FIG. 1, an antenna carried on an aircraft may receive positioning information sent by a satellite, and a C-axis refers to an axis perpendicular to the ground. An angle at which the aircraft rotates along the C-axis is an azimuth angle.

4. Antenna pattern.

The antenna pattern may be a graph showing how relative field strength (normalized modulus value) of a radiation field varies with a direction around the antenna, and is generally represented by using two mutually perpendicular plane patterns in a maximum radiation direction of the antenna. It may be understood that, in some cases, the antenna pattern may further be represented by using a table of two orthogonal vectors. For example, as shown in FIG. 1:

**Table 1**

| θ[deg] | φ[deg] | | | | | | | |
|---|---|---|---|---|---|---|---|---|
| | 0 | | 5 | | ... | | 360 | |
| 0 | Amp0-θ | Amp0-φ | Amp0-θ | Amp5-φ | ... | ... | Amp0-θ | Amp360-φ |
| | Angle0-θ | Angle0-φ | Angle0-θ | Angle5-φ | ... | ... | Angle0-θ | Angle360-φ |
| 5 | Amp5-θ | Amp0-φ | Amp5-θ | Amp5-φ | ... | ... | Amp5-θ | Amp360-φ |
| ... | ... | ... | ... | ... | ... | ... | ... | ... |
| | ... | ... | ... | ... | ... | ... | ... | ... |
| 180 | Amp180-θ | Amp0-φ | Amp180-θ | Amp5-φ | ... | ... | Amp180-θ | Amp360-φ |
| | Angle180-θ | Angle0-φ | Angle180-θ | Angle-φ | ... | ... | Angle180-θ | Angle360-φ |

Here, θ may represent the left-hand circularly polarized vector of the antenna. φ may represent the right-hand circularly polarized vector of the antenna. Amp0-θ and Angle0-θ may represent a left-hand circularly polarized vector of a signal when an azimuth angle is 0° and a pitch angle is 0°, and Amp0-φ and Angle0-φ represents a right-hand circularly polarized vector of a signal when an azimuth angle is 0° and a pitch angle is 0°; Amp0-θ and Angle0-θ may represent a left-hand circularly polarized vector of a signal when an azimuth angle is 0° and a pitch angle is 5°, and Amp5-φ and Angle5-φ may represent a right-hand circularly polarized vector of a signal when an azimuth angle is 0° and a pitch angle is 5°; and so on. It may be understood that an antenna pattern typically represents the signal amplitude and phase values at azimuth angles of 0°-180° and the signal amplitude and phase values at pitch angles of 0°-360°.

5. Direct-path signal.

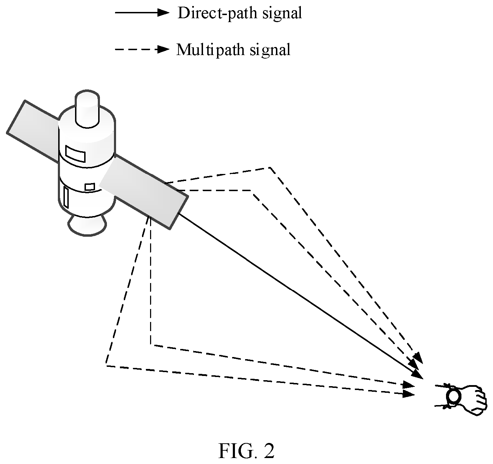

The satellite sends positioning signals to the receiving device, and the receiving device may receive, via a plurality of paths, the positioning signals sent by the satellite. For example, as shown in FIG. 2, the receiving device may receive, via a plurality of paths, positioning signals sent by the satellite, where a path for transmission along a straight line, that is, a path with a shortest length, is a direct-path signal. It may be understood that the direct-path signal is the first signal received by the receiving device, and has the highest amplitude.

6. Multipath signal.

Still as shown in FIG. 2, in addition to the foregoing direct-path signal, some positioning signals that are sent by the satellite may also be received by the receiving device through reflections from obstacles. These signals may be referred to as multipath signals. It may be understood that the multipath signal is received by the receiving device through reflection from an obstacle. Therefore, a transmission path of the multipath signal is longer than a transmission path of the direct-path signal. As a result, a receiving moment of the multipath signal is generally later than a receiving moment of the direct-path signal (that is, a delay exists in the multipath signal), and signal attenuation of the multipath signal is also generally greater than signal attenuation of the direct-path signal. Therefore, a signal amplitude of the multipath signal is also generally less than a signal amplitude of the direct-path signal.

The data processing method provided in embodiments of this application may be applied to an electronic device. Optionally, the electronic device includes a terminal device. The terminal device may also be referred to as a terminal (terminal), user equipment (user equipment, UE), a mobile station (mobile station, MS), a mobile terminal (mobile terminal, MT), or the like. The terminal device may be a mobile phone (mobile phone), a smart TV, a wearable device, a tablet computer (Pad), a computer having a wireless transceiver function, a virtual reality (virtual reality, VR) terminal device, an augmented reality (augmented reality, AR) terminal device, a wireless terminal in industrial control (industrial control), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like. A specific technology and a specific device form that are used by the terminal device are not limited in the embodiments of this application.

For example, the terminal device provided in embodiments of this application may be a smart bracelet.

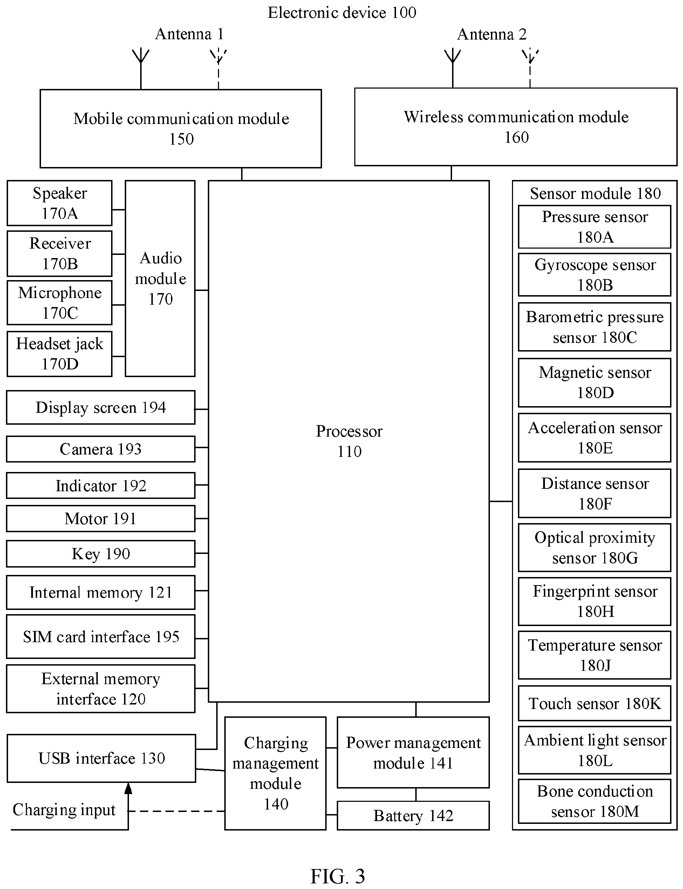

For example, FIG. 3 is a schematic diagram of a structure of an electronic device 100. The electronic device 100 may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a key 190, a motor 191, an indicator 192, a camera 193, a display screen 194, a subscriber identification module (subscriber identification module, SIM) card interface 195, and the like. The sensor module 180 may include a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

It can be understood that the structure illustrated in this embodiment of this application constitutes no specific limitation on the electronic device 100. In some other embodiments of this application, the electronic device 100 may include more or fewer components than those shown in the figure, combine some components, split some components, or have different component arrangements. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a memory, a video codec, a digital signal processor (digital signal processor, DSP), a baseband processor, a neural-network processing unit (neural-network processing unit, NPU), and/or the like. Different processing units may be independent devices, or may be integrated into one or more processors.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/-transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

A wireless communication function of the electronic device 100 may be implemented by using the antenna 1, the antenna 2, the mobile communication module 150, the wireless communication module 160, the modem processor, the baseband processor, and the like.

The antenna 1 and the antenna 2 are configured to transmit and receive electromagnetic wave signals. Each antenna in the electronic device 100 may be configured to cover one or more communication frequency bands. Different antennas may be further multiplexed to improve antenna utilization. For example, the antenna 1 may be reused as a diversity antenna of a wireless local area network. In some other embodiments, the antenna may be used together with a tuning switch.

The mobile communication module 150 may provide a solution applied to the electronic device 100 for wireless communication including 2G/3G/4G/5G and the like. The mobile communication module 150 may include at least one filter, switch, power amplifier, low noise amplifier (low noise amplifier, LNA), and the like. The mobile communication module 150 may receive an electromagnetic wave through the antenna 1, perform processing such as filtering or amplification on the received electromagnetic wave, and transmit a processed electromagnetic wave to the modem processor for demodulation. The mobile communication module 150 may further amplify a signal obtained after modulation by the modem processor, and convert an amplified signal into an electromagnetic wave for radiation through the antenna 1. In some embodiments, at least some functional modules in the mobile communication module 150 may be disposed in the processor 110. In some embodiments, at least some functional modules in the mobile communication module 150 may be disposed in a same device as at least some modules in the processor 110.

The modem processor may include a modulator and a demodulator. The modulator is configured to modulate a to-be-sent low frequency baseband signal into a medium or high frequency signal. The demodulator is configured to demodulate a received electromagnetic wave signal into a low-frequency baseband signal. Then, the demodulator transfers, to the baseband processor for processing, the low frequency baseband signal obtained through demodulation. The low-frequency baseband signal is processed by the baseband processor and then transferred to the application processor. The application processor outputs a sound signal by using an audio device (not limited to the speaker 170A, the receiver 170B, and the like), or displays an image or a video by using the display 194. In some embodiments, the modem processor may be an independent device. In some other embodiments, the modem processor may be independent of the processor 110 and disposed in a same device as the mobile communication module 150 or another functional module.

The wireless communication module 160 may provide a solution for wireless communication that is applied to the electronic device 100 and that includes a wireless local area network (wireless local area networks, WLAN) (for example, a wireless fidelity (wireless fidelity, Wi-Fi) network), Bluetooth (bluetooth, BT), a global navigation satellite system (global navigation satellite system, GNSS), frequency modulation (frequency modulation, FM), a near field communication (near field communication, NFC) technology, an infrared (infrared, IR) technology, and the like. The wireless communication module 160 may be one or more devices integrating at least one communication processing module. The wireless communication module 160 receives an electromagnetic wave through the antenna 2, performs frequency modulation and filtering on an electromagnetic wave signal, and sends a processed signal to the processor 110. The wireless communication module 160 may further receive a to-be-sent signal from the processor 110, perform frequency modulation and amplification on the to-be-sent signal, and convert, through the antenna 2, the to-be-sent signal into an electromagnetic wave for radiation.

In some embodiments, in the electronic device 100, the antenna 1 is coupled to the mobile communication module 150, and the antenna 2 is coupled to the wireless communication module 160, so that the electronic device 100 can communicate with a network and another device according to a wireless communication technology. The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), the 5th Generation of wireless communication system (5G, the 5th Generation of wireless communication system), BT, GNSS, WLAN, NFC, FM, an IR technology, and/or the like. The GNSS may include a global positioning system (global positioning system, GPS), a global navigation satellite system (global navigation satellite system, GLONASS), a BeiDou navigation satellite system (beidou navigation satellite system, BDS), a quasi-zenith satellite system (quasi-zenith satellite system, QZSS), and/or a satellite based augmentation system (satellite based augmentation systems, SBAS).

The electronic device 100 implements a display function by using the GPU, the display 194, the application processor, and the like. The GPU is a microprocessor for image processing, and is connected to the display 194 and the application processor. The GPU is configured to perform mathematical and geometric computation, for image rendering. The processor 110 may include one or more GPUs that execute program instructions to generate or change display information.

It should be noted that any electronic device mentioned in this embodiment of this application may include more or fewer modules than those in the electronic device 100.

An application scenario of embodiments of this application is described below with reference to the accompanying drawings.

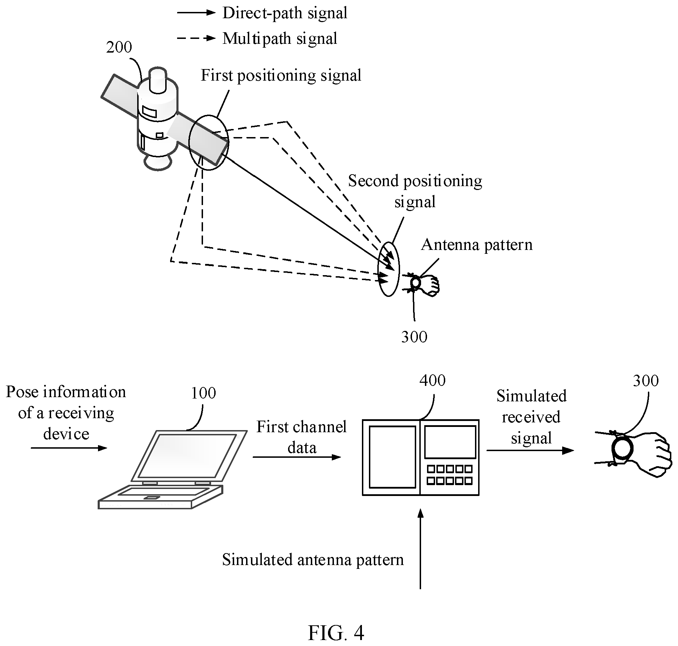

FIG. 4 is a schematic diagram of an application scenario of a data processing method according to an embodiment of this application. As shown in FIG. 4, a satellite 200 sends a first positioning signal to a receiving device (for example, a smart bracelet) 300, and the first positioning signal is received by the receiving device through a first channel. In this case, the signal received by the receiving device 300 may be a combined signal (a second positioning signal) formed by a direct-path signal and a multipath signal. It may be understood that the second positioning signal is a signal that is input to the receiving device 300, and the second positioning signal needs to pass through an antenna of the receiving device 300 to reach a processor, where the signal is processed by the processor to determine position information of the receiving device 300. After the first positioning signal passes through the first channel, the first positioning signal needs to pass through the antenna of the receiving device before it can be received by the first electronic device. Generally, the second positioning signal refers to a signal after the antenna in the first electronic device. It may be understood that, after the signal passes through the antenna, the signal is affected by an antenna pattern of the antenna and then changes. Therefore, the second positioning signal and the first positioning signal are different signals when reaching a receiving port of the first electronic device through the first channel.

In some possible cases, a signal received by the receiving device 300 may alternatively be a combined signal that includes only a plurality of multipath signals. This is not limited in this embodiment of this application.

In this case, elevation information and latitude and longitude information of the current receiving device 300 may be first obtained, and first channel data between the satellite 200 and the receiving device 300 may be calculated through simulation by using the electronic device 100. Then, the first channel data obtained through simulation and calculation and a simulated antenna pattern simulating the antenna in the receiving device 300 are input into a satellite simulator 400, and simulated received data corresponding to the second positioning signal is simulated by using the satellite simulator 400. In this case, the simulated received data is sent to the receiving device 300. The simulated received data is processed by the processor in the receiving device 300 to obtain location data corresponding to the simulated received data, and the location data corresponding to the simulated received data is then compared with actual location information of the receiving device, so as to evaluate impact of antenna parameters in the receiving device 300 on positioning accuracy of the satellite.

The satellite 200 may be a Beidou positioning satellite, a GPS positioning satellite, a Galileo satellite, or a GLONASS satellite. This is not limited in this embodiment of this application. In a possible case, the foregoing satellite 200 may alternatively be a combination of at least two of the foregoing satellites. It should be noted that a same satellite may generally transmit signals of a plurality of frequency bands. The data processing method provided in this embodiment of this application may be for one transmit frequency band of a satellite, or may be for a plurality of transmit frequency bands of a satellite.

It should be understood that the foregoing is an example for describing an application scenario, and no limitation is imposed on the application scenario of this application.

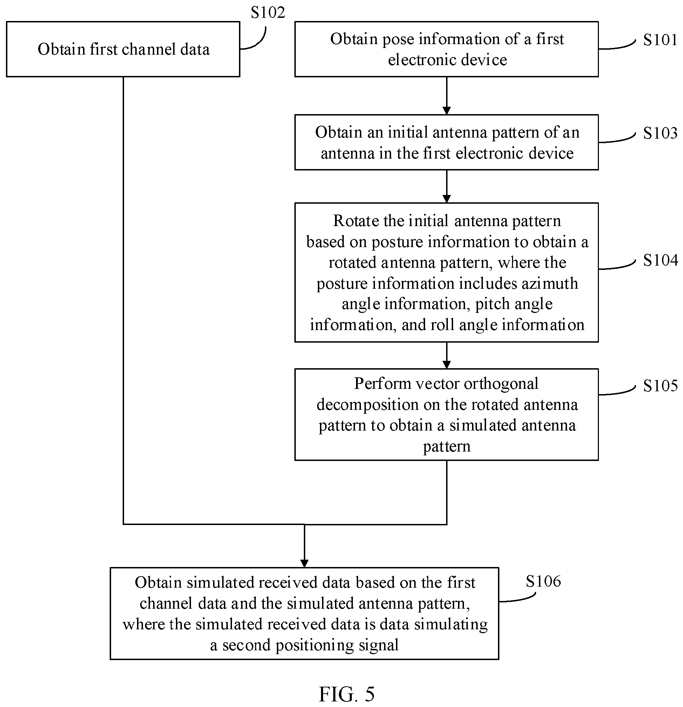

The following describes in detail the data processing method provided in embodiments of this application with reference to FIG. 5 to FIG. 10.

FIG. 5 is a schematic flowchart of a data processing method according to an embodiment of this application. As shown in FIG. 5, the method includes:
S101. Obtain pose information of a first electronic device.

The first electronic device may be configured to receive a second positioning signal, and determine location information of the first electronic device based on the second positioning signal. The second positioning signal is a signal obtained when a first positioning signal sent by a second electronic device passes through a first channel, and the first channel is a channel between the first electronic device and the second electronic device.

It should be noted that the first electronic device may be a smart bracelet or another device that receives a positioning signal sent by the second electronic device. This is not limited in this embodiment of this application. The second electronic device may be a satellite, or may be another positioning signal sending device. This is not limited in this embodiment of this application.

An example in which the first electronic device is a smart bracelet and the second electronic device is a satellite is used for description in the following.

The pose information of the smart bracelet may include location information and/or posture information of the smart bracelet. The location information may be elevation information and latitude and longitude information of the smart bracelet at a current moment, and the posture information may be azimuth angle information, pitch angle information, and roll angle information of the smart bracelet at a current moment.

For example, the pose information may be location information of the smart bracelet at a current moment.

For another example, the pose information may be location information and posture information of the smart bracelet at a current moment.

The smart bracelet may obtain the elevation information and the latitude and longitude information of the smart bracelet at the current moment, to determine the location information of the smart bracelet.

The smart bracelet may obtain coordinate information of the smart bracelet at each sampling moment, and further obtain the posture information of the smart bracelet based on a coordinate change at each moment.

In a possible case, the obtaining the posture information of the smart bracelet may be moving the smart bracelet according to a preset path, and simultaneously obtaining coordinate information of the smart bracelet at each sampling moment according to a preset sampling period, so as to determine the pose information of the smart bracelet based on the collected coordinate information.

In a possible case, the posture information of the smart bracelet may alternatively be obtained through simulation and calculation.

For example, as shown in FIG. 6, when a user wears a smart bracelet to run in a straight line, coordinates of the smart bracelet change periodically as the arm of the user swings. As shown in FIG. 6, in the first arm swing period, that is, a period from moment T10 to moment T16, a coordinate change of the smart bracelet is shown in FIG. 6. In another arm swing period, for example, a period from moment T20 to moment T26 (not shown in the figure), a period from moment T30 to moment T36 (not shown in the figure), ..., and so on, coordinate changes of the smart bracelet are similar to the coordinate change in the first arm swing period.

For example, as shown in FIG. 2, in an arm swing period, sampling is performed once every T0 duration, and sampling is performed a total of (2N-1) times. In the first sampling period, a coordinate change of the smart bracelet along with an arm swing movement is shown in Table 3. At moment 1T0, the smart bracelet has an X-axis coordinate X1, a Y-axis coordinate Y1, and a Z-axis coordinate Z1; at moment 2T0, the smart bracelet has an X-axis coordinate X2, a Y-axis coordinate Y2, and a Z-axis coordinate Z2; ...; and up to moment (2N-2)T0, the smart bracelet has an X-axis coordinate X(2N-2), a Y-axis coordinate Y(2N-2), and a Z-axis coordinate Z(2N-2). At moment (2N-1)T0, that is, at a first sampling moment of the second period, the smart bracelet has an X-axis coordinate X1, a Y-axis coordinate Y1, and a Z-axis coordinate Z1. Then coordinates of the smart bracelet on the X-axis, the Y-axis, and the Z-axis change according to the coordinate change in the first period.

**Table 2**

| Moment | T | 1*T0 | 2*T0 | ... | N*T0 | (N+1)*T0 | ... | (2N-2)*T0 | (2N-1)*T0 | 2N*T0 |
|---|---|---|---|---|---|---|---|---|---|---|
| Posture | X-axis | X1 | X2 | ... | XN | X(N+1) | ... | X(2N-2) | X1 | X2 |
|  | Y-axis | Y1 | Y2 | ... | YN | Y(N+1) | ... | Y(2N-2) | Y1 | Y2 |
|  | Z-axis | Z1 | Z2 | ... | ZN | Z(N+1) | ... | Z(2N-2) | Z1 | Z2 |

That a speed of a straight-line movement of the user is a constant speed is used as an example. A coordinate change caused by the straight-line movement of the user may be shown in Table 3. As shown in Table 3, in the first sampling period, at moment 1T0, the smart bracelet has an X-axis coordinate 0, a Y-axis coordinate V*T0, and a Z-axis coordinate 0; at moment 2T0, the smart bracelet has an X-axis coordinate 0, a Y-axis coordinate V*2T0, and a Z-axis coordinate 0; ...; and up to moment (2N-2)T0, the smart bracelet has an X-axis coordinate 0, a Y-axis coordinate V*(2N-2)T0, and a Z-axis coordinate 0. At moment (2N-1)T0, that is, the first sampling moment in the second period, the smart bracelet has an X-axis coordinate 0, a Y-axis coordinate V*(2N-1)T0, and a Z-axis coordinate 0. Here, V represents a speed at which the user moves at a constant speed.

**Table 3**

| Moment | T | 1*T0 | 2*T0 | ... | N*T0 | (N+1)*T0 | ... | (2N-2)*T0 | 2N*T0 |
|---|---|---|---|---|---|---|---|---|---|
| Posture | X-axis | 0 | 0 | ... | 0 | 0 | ... | 0 | 0 |
|  | Y-axis | v*T0 | v*2T0 | ... | v*NT0 | v*(N+1)T0 | ... | v*(2N-2)T0 | v*2NT0 |
|  | Z-axis | 0 | 0 | ... | 0 | 0 | ... | 0 | 0 |

The coordinate change in Table 2 and the coordinate change in Table 3 may be combined, to obtain a coordinate change of the smart bracelet when the user moves at a constant speed along a straight line.

In a possible case, when the user wears the smart bracelet and moves along a curve, coordinates of the smart bracelet change periodically as the arm of the user swings. For example, a coordinate change of the smart bracelet caused by the arm swing movement of the user may be shown in Table 2, and details are not described herein again.

An example in which the user moves along a curve is a combination of uniform motion along a 90° arc and straight-line motion. A coordinate change of the user moving along the curve may be shown in Table 4. As shown in Table 4, in the first sampling period, the user moves along a 90° arc at a uniform speed, and at moment 1T0, the smart bracelet has an X-axis coordinate 0, a Y-axis coordinate $V*T0*2/\pi$, and a Z-axis coordinate 0; at moment 2T0, the smart bracelet has an X-axis coordinate $V*2T0*2/\pi*\sin(1*\pi/2N)$, a Y-axis coordinate $V*2T0*2/\pi*\cos(1*\pi/2N)$, and a Z-axis coordinate 0; and so on. In the second period, that is, at moment N*T0, the smart bracelet has an X-axis coordinate $v*N*T0*2/\pi$, a Y-axis coordinate 0, and a Z-axis coordinate 0; and at moment (N+1)T0, the smart bracelet has an X-axis coordinate $v*N*T0*2/\pi$, a Y-axis coordinate V*T0, and a Z-axis coordinate 0. At moment (2N-1)T0, that is, the first sampling moment of the second period, the smart bracelet has an X-axis coordinate $v*N*T0*2/\pi$, a Y-axis coordinate V*(N-1)T0, and a Z-axis coordinate 0. Here, V represents a speed at which the user moves at a constant speed.

**Table 4**

|  |  | 90° arc motion |  |  |  | Straight-line motion |  |  |  |
|---|---|---|---|---|---|---|---|---|---|
| Moment | T | 1*T0 | 2*T0 | 3*T0 | ... | N*T0 | (N+1)*T0 | ... | (2N-1)*T0 |
| Running route | X | 0 | v*2T0*2/π*sin (1*π/2N) | v*3T0*2/π*sin (2*π/2N) | ... | v*NT0 *2/π | v*NT0*2/π | ... | v*NT0*2/π |
|  | Y | v*T0* 2/π | v*2T0*2/π*cos (1*π/2N) | v*3T0*2/π*cos (2*π/2N) | ... | 0 | v*T0 | ... | v*(N-1)T0 |

(continued)

| | | 90° arc motion | | | | Straight-line motion | | | |
|---|---|---|---|---|---|---|---|---|---|
| Moment | T | 1*T0 | 2*T0 | 3*T0 | ... | N*T0 | (N+1)*T0 | ... | (2N-1)*T0 |
| | Z | 0 | 0 | 0 | ... | 0 | 0 | ... | 0 |

The coordinate change in Table 2 and the coordinate change in Table 4 may be combined, to obtain a coordinate change of the smart bracelet when the user moves at a constant speed along a curve.

After the coordinate change of the smart bracelet is obtained, posture information of the smart bracelet may be obtained by comparing coordinate changes of the smart bracelet at different moments.

S102. Obtain first channel data, where the first channel data is data simulating a state of a channel between the first electronic device and the second electronic device.

To obtain the first channel data, the elevation information and the latitude and longitude information of the smart bracelet at the current moment may be obtained to obtain the location information, and then the first channel data between the smart bracelet and the satellite is obtained through simulation and calculation based on the location information of the smart bracelet at the current moment.

Optionally, the first channel data may include one piece of simulated direct-path (Line of Sight, LOS) data and N pieces of simulated multipath (Not Line of Sight, NLOS) data. A quantity of first sub-vectors is N+1, a quantity of second sub-vectors is N+1, the simulated direct-path data is corresponding to one first sub-vector and one second sub-vector, and the N pieces of simulated multipath data are respectively in one-to-one correspondence with the N first sub-vectors and the N second sub-vectors.

The first channel data may be represented by using the table shown in Table 5. As shown in Table 5, the first channel data may be:

**Table 5**

| Path | Delay (ns) | $\varphi$(deg) | $\theta$(deg) | AMP-$\theta$(dB) | Angle-$\theta$(deg) | AMP-$\varphi$(dB) | Angle-$\varphi$(deg) |
|---|---|---|---|---|---|---|---|
| LOS | 0 | 220.5 | 95.5 | 1.52 | -121.53 | -13.60 | -78.51 |
| NLOS1 | 5.84 | 19.5 | 119 | -12.51 | 6.91 | -20.54 | -141.15 |
| NLOS2 | 6.94 | 350 | 126 | -13.04 | 161.37 | -14.59 | 140.07 |
| ... | ... | ... | ... | ... | ... | ... | ... |
| NLOSN | 4.49 | 191 | 90.5 | -5.11 | -133.59 | -12.37 | 125.69 |

It may be understood that one piece of direct-path data includes one first sub-vector and one second sub-vector, and each piece of simulated multipath data may also include one first sub-vector and one second sub-vector.

Any one piece of data of the simulated direct-path data and the N pieces of simulated multipath data may be represented by using Formula (1). For example, the simulated direct-path data may be represented by using Formula (1).

$$\overrightarrow{E_{\theta 1}}A_{\theta 1}e^{j\theta 1} + \overrightarrow{E_{\varphi 1}}A_{\varphi 1}e^{j\varphi 1} \qquad \text{Formula (1)}.$$

Here, $\overrightarrow{E_{\theta 1}}A_{\theta 1}e^{j\theta 1}$ may represent the first left-hand circularly polarized vector, and $\overrightarrow{E_{\varphi 1}}A_{\varphi 1}e^{j\varphi 1}$ may represent the second right-hand circularly polarized vector.

In a possible case, the first channel data may alternatively include only a plurality of pieces of multipath data, and does not include the direct-path data.

For example, the first channel data may include (N+1) pieces of simulated multipath data, and any piece of data in each piece of simulated multipath data may be represented by using the foregoing Formula (1).

S103. Obtain an initial antenna pattern of the antenna in the first electronic device.

The electronic device may obtain the initial antenna pattern of the antenna through calculation based on environment information, size information, and the like of the antenna on the smart bracelet. For example, the electronic device may perform simulation and calculation on the environment information and the size information of the antenna on the smart bracelet by using simulation software, to obtain the initial antenna pattern.

The initial antenna pattern may include a third sub-vector and a fourth sub-vector, and the third sub-vector and the fourth sub-vector may be sub-vectors obtained by performing orthogonal vector decomposition on the initial antenna pattern. For example, the third sub-vector may be a second left-hand circularly polarized vector, and the fourth sub-vector may be a second right-hand circularly polarized vector.

It may be understood that the third sub-vector may be a second left-hand circularly polarized vector, and the fourth sub-vector may be a second right-hand circularly polarized vector, which does not constitute a limitation on the third sub-vector and the fourth sub-vector. The third sub-vector and the fourth sub-vector in the initial antenna pattern may also be sub-vectors obtained in another decomposition manner. For example, the third sub-vector may be a vertically polarized vector, and the fourth sub-vector may be a horizontally polarized vector.

The obtained initial antenna pattern may be represented by using Formula (2). Formula (2) includes:

$$\overrightarrow{E_{\theta 2}} A_{\theta 2} e^{j\theta 2} + \overrightarrow{E_{\varphi 2}} A_{\varphi 2} e^{j\varphi 2} \qquad \text{Formula (2).}$$

Here, $\overrightarrow{E_{\theta 2}} A_{\theta 2} e^{j\theta 2}$ may represent the second left-hand circularly polarized vector, and $\overrightarrow{E_{\varphi 2}} A_{\varphi 2} e^{j\varphi 2}$ may represent the second right-hand circularly polarized vector.

S104. Rotate the initial antenna pattern based on posture information to obtain a rotated antenna pattern, where the posture information includes azimuth angle information, pitch angle information, and roll angle information.

In a process of using the receiving device, as the user moves, the antenna pattern changes accordingly, for example, coordinates change as shown in the foregoing Table 2, Table 3, and Table 4. In a possible case, when the user wears the smart bracelet and moves, coordinates of the smart bracelet change with an arm swing action of the user. In this case, the initial antenna pattern is rotated based on the pose information of the receiving device, to obtain the rotated antenna pattern, which can be closer to an antenna pattern in actual use. For example, the antenna pattern may be rotated based on posture information of the smart bracelet at a current moment and posture information of the smart bracelet at an initial moment, so that the rotated antenna pattern can be closer to the antenna pattern of the receiving device at the current moment, thereby improving accuracy of the simulated received data determined based on the antenna pattern.

For example, the smart bracelet may determine a rotation matrix R based on the pose information at the current moment and the pose information at the initial moment (a moment corresponding to the initial antenna pattern), and may rotate the antenna pattern at the current moment (that is, the initial antenna pattern) by using the rotation matrix R, to obtain the rotated antenna pattern.

Rotation of the initial antenna pattern may be rotation of each point in the initial antenna pattern. The following describes how to perform rotation by using one point in the initial antenna pattern, that is, point A as an example.

For example, as shown in (a) in FIG. 7, the initial antenna pattern may include a plurality of points, where point A is a point in the initial antenna pattern. A signal at point A may be represented by using Formula (2). As shown in (a) in FIG. 7, the signal at point A includes $E_{\theta 2}$ component and $E_{\varphi 2}$ component.

In this case, the rotation matrix R is determined based on the posture information of the smart bracelet, and then point A in the initial antenna pattern is rotated based on the rotation matrix R, to obtain point *A'* in a rotated antenna pattern. A signal of point *A'* may also be represented by using Formula (3), that is:

$$\overrightarrow{E'_{\theta 2}} A_{\theta 2} e^{j\theta 2} + \overrightarrow{E'_{\varphi 2}} A_{\varphi 2} e^{j\varphi 2} \qquad \text{Formula (3).}$$

As shown in (b) in FIG. 7, the signal of point *A'* includes $E'_{\theta 2}$ component and $E'_{\varphi 2}$ component. It can be learned that a direction of $E_{\theta 2}$ component is different from that of $E'_{\theta 2}$ component, and a direction of $E_{\varphi 2}$ component is different from that of $E'_{\varphi 2}$ component.

If the rotated antenna direction and the first channel data are directly used to determine the simulated received data, because a direction of the signal component of the rotated antenna pattern is different from a direction of the signal component of the initial antenna pattern, the simulated received data determined by using the rotated antenna direction and the first channel data may be distorted, and a difference between the simulated received data and second positioning data is relatively large. In this case, vector orthogonal decomposition may be performed on the rotated antenna pattern, so that the direction of the signal component of the simulated antenna pattern is the same as the direction of the signal component of the initial antenna pattern, thereby reducing the distortion of the simulated received data determined based on the rotated antenna direction and the first channel data.

S105. Perform vector orthogonal decomposition on the rotated antenna pattern to obtain the simulated antenna pattern.

For example, as shown in (c) in FIG. 7, vector orthogonal decomposition is performed on the rotated antenna pattern to obtain the simulated antenna pattern, where point A‴ in the simulated antenna pattern is a point obtained after vector orthogonal decomposition is performed on point *A'* in the rotated antenna pattern. A signal at point *A‴* may be represented by using Formula (4), that is:

$$\overrightarrow{E''_{\theta 2}} A_{\theta 2} e^{j\theta 2} + \overrightarrow{E''_{\varphi 2}} A_{\varphi 2} e^{j\varphi 2} \qquad\qquad \text{Formula (4).}$$

As shown in (c) in FIG. 7, the signal at point $A$ includes $E''_{\theta 2}$ component and $E''_{\varphi 2}$ component. It can be learned that the direction of $E'_{\theta 2}$ component is different from that of $E''_{\theta 2}$ component, but the direction of $E_{\theta 2}$ component is the same as that of $E''_{\theta 2}$ component; and the direction of $E'_{\varphi 2}$ component is different from that of $E''_{\varphi 2}$ component, but the direction of $E_{\theta 2}$ component is the same as that of $E''_{\varphi 2}$ component.

In a possible case, $E_{\theta 2}$ component and $E''_{\theta 2}$ component may be left-hand circularly polarized vectors; and $E_{\theta 2}$ component and $E''_{\varphi 2}$ component may be right-hand circularly polarized vectors.

The initial antenna pattern includes the second left-hand circularly polarized vector and the second right-hand circularly polarized vector, the simulated antenna pattern includes a third left-hand circularly polarized vector and a third right-hand circularly polarized vector, a direction of the second left-hand circularly polarized vector is the same as a direction of the third left-hand circularly polarized vector, and a direction of the second right-hand circularly polarized vector is the same as a direction of the third right-hand circularly polarized vector.

According to the data processing method provided in this embodiment of this application, in a process of obtaining the simulated received data by using the first channel data and the simulated antenna pattern, the simulated antenna pattern is obtained by correcting the initial antenna pattern by using the posture information of the electronic device to obtain a rotated antenna pattern, and correcting a direction of a vector of the rotated antenna pattern through orthogonal vector decomposition, so that the finally obtained simulated antenna pattern can be closer to an antenna pattern of the receiving device in an actual use process, and the direction of the vector is the same as the initial antenna pattern. In this way, the simulated received data obtained based on the first channel data and the simulated antenna pattern is more accurate, thereby improving accuracy of an actual positioning signal obtained based on the simulated received data.

S106. Obtain the simulated received data based on the first channel data and the simulated antenna pattern, where the simulated received data is data simulating a second positioning signal, the second positioning signal is a signal obtained when a first positioning signal sent by the second electronic device is received by the antenna in the first electronic device, and the second positioning signal is used for determining location information of the first electronic device.

The first channel data may be represented by using Formula (1), the simulated antenna pattern may be represented by using Formula (4), and the simulated received data may be represented by a product of Formula (1) and Formula (4), that is, Formula (5):

$$(\overrightarrow{E_{\theta 1}} A_{\theta 1} e^{j\theta 1} + \overrightarrow{E_{\varphi 1}} A_{\varphi 1} e^{j\varphi 1}) * (\overrightarrow{E''_{\theta 2}} A_{\theta 2} e^{j\theta 2} + \overrightarrow{E''_{\varphi 2}} A_{\varphi 2} e^{j\varphi 2})$$

$$= A_{\theta 1} e^{j\theta 1} * A_{\theta 2} e^{j\theta 2} + A_{\varphi 1} e^{j\varphi 1} * A_{\varphi 2} e^{j\varphi 2}$$

$$= A_{\theta 1} * A_{\theta 2} e^{j(\theta 1 + \theta 2)} + A_{\varphi 1} A_{\varphi 2} e^{j(\varphi 1 + \varphi 2)} \qquad\qquad \text{Formula (5).}$$

It may be understood that the obtained first channel data and simulated antenna pattern may be obtained through calculation, for example, obtained through simulation and calculation. The first channel data and the simulated antenna pattern may be used as input data and input into a satellite simulator. The satellite simulator may obtain the simulated received data based on the foregoing Formula (5). Then the satellite simulator may send the simulated received data to the smart bracelet, so that the smart bracelet determines corresponding location information based on the simulated received data, and then may determine location information of the smart bracelet based on the simulated received data, to determine whether a parameter of the antenna in the smart bracelet affects satellite positioning accuracy.

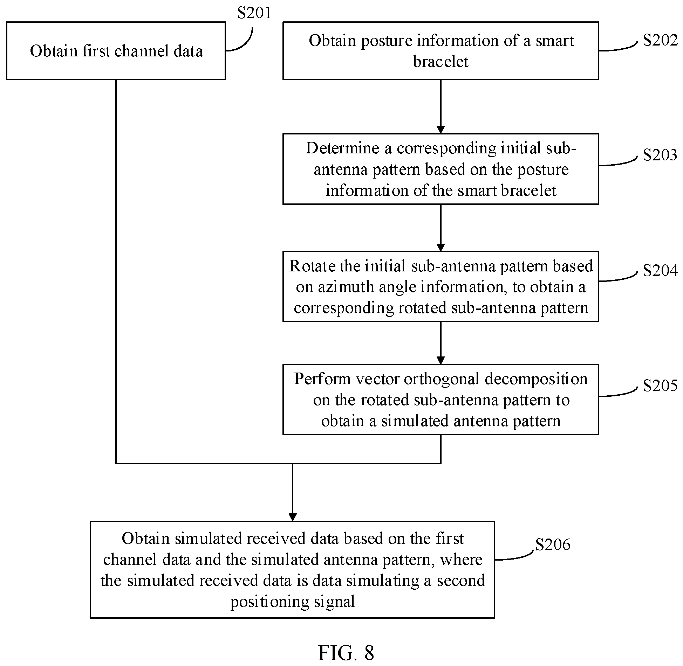

In a possible case, the posture information of the smart bracelet is azimuth angle information. Movement of the smart bracelet further causes a change of a pitch angle and a roll angle. It may be understood that changes of the pitch angle and the roll angle of the smart bracelet caused by an arm swing action of the user are generally related to an arm swing angle of the user. Therefore, in this case, a corresponding sub-initial antenna pattern may be chosen based on an arm swing angle of the user, and is rotated separately, so as to obtain a simulated antenna direction. The following is described in detail by using FIG. 8.

FIG. 8 is a schematic flowchart of another data processing method according to an embodiment of this application. As shown in FIG. 8, the method includes:

S201. Obtain first channel data.

The first channel data is data simulating a state of a channel between a smart bracelet and a satellite, and may be obtained by obtaining elevation information and latitude and longitude information of the smart bracelet and then performing simulation and calculation based on the elevation information and the latitude and longitude information.

S202. Obtain posture information of the smart bracelet.

The posture information may be azimuth angle information.

For a specific process of obtaining the posture information of the smart bracelet, that is, a specific process of obtaining the azimuth angle information of the smart bracelet, refer to the foregoing method step shown in S101. Details are not described herein again.

It should be noted that the azimuth angle information, roll angle information, and pitch angle information may be obtained according to the method step shown in S101. In the step shown in S202, only the azimuth angle information may be obtained through calculation.

S203. Determine a corresponding initial sub-antenna pattern based on the posture information of the smart bracelet.

There may be N initial sub-antenna patterns, and each initial sub-antenna pattern is related to the posture information of the smart bracelet.

It may be understood that, as the user swings the arm, a location of the smart bracelet relative to the user also changes. The human body affects the antenna pattern. Therefore, with a change of the location of the smart bracelet relative to the user, the human body affects the antenna pattern of the antenna in the smart bracelet. That is, as the user swings the arm, a relative location relationship between the smart bracelet and the human body changes, which causes a change of environment information of the antenna in the smart bracelet, and further leads to a change of a simulated antenna pattern of the antenna in the smart bracelet. In this case, corresponding initial sub-antenna patterns may be selected for different arm swing angles of the user, so that the selected initial sub-antenna pattern can be close to an antenna pattern in an actual use process.

For example, arm positions with an included angle between the arm and the horizontal direction being [0°, -30°) may be classified as a category 1, arm positions with an included angle between the arm and the horizontal direction being (-30°, -60°] are classified as a category 2, and arm positions with an included angle between the arm and the horizontal direction being (-60°, -90°] are classified as a category 3. Then, a corresponding initial sub-antenna pattern is selected for arm positions of a same category.

It may be understood that the foregoing classification of arm positions is merely an example, and does not constitute a limitation on the classification of arm positions.

For arm positions of a same category, one of the arm positions may be selected to determine an initial antenna pattern. For example, for an arm position in the category 1, an arm position with an angle of -15° between the arm and the horizontal direction may be selected as a sample, and then the arm position with the angle of -15° between the arm and the horizontal direction and environment information of the human body as an antenna of the smart bracelet are simulated to obtain an initial sub-antenna pattern 1. For an arm position in the category 2, an arm position with an angle of -45° between the arm and the horizontal direction may be selected as a sample, and then the arm position with the angle of -45° between the arm and the horizontal direction and environment information of the human body as an antenna of the smart bracelet are simulated to obtain an initial sub-antenna pattern 2. For an arm position in the category 3, an arm position with an angle of -90° between the arm and the horizontal direction may be selected as a sample, and then the arm position with the angle of -90° between the arm and the horizontal direction and environment information of the human body as an antenna of the smart bracelet are simulated to obtain an initial sub-antenna pattern 3.

S204. Rotate the initial sub-antenna pattern based on the azimuth angle information, to obtain a corresponding rotated sub-antenna pattern.

Rotation of the initial sub-antenna pattern is similar to the method step shown in S104. Details are not described herein again.

There are N initial sub-antenna patterns, and correspondingly, there are N rotated sub-antenna patterns.

S205. Perform vector orthogonal decomposition on the rotated sub-antenna pattern to obtain a simulated antenna pattern.

For performing vector orthogonal decomposition on the rotated sub-antenna pattern, refer to the method step shown in S105. Details are not described herein again.

It may be understood that a quantity of rotated sub-antenna patterns is also N, and vector orthogonal decomposition is performed on the N rotated sub-antenna patterns to obtain N simulated sub-antenna patterns. That is, the simulated antenna direction may include N simulated sub-antenna patterns.

S206. Obtain simulated received data based on the first positioning data and the simulated antenna pattern.

The simulated antenna pattern may include N simulated sub-antenna patterns. Therefore, the obtaining the simulated received data based on the simulated antenna pattern and the first positioning data may be obtaining N pieces of simulated sub-received data respectively based on the N simulated sub-antenna patterns and the first positioning data, and then obtaining the simulated received data based on the N pieces of simulated sub-received data.

For a specific process of obtaining the simulated sub-received data based on the first positioning data and the simulated sub-antenna pattern, refer to the foregoing method step shown in S106. Details are not described herein again.

According to the data processing method provided in this embodiment of this application, the first channel data is obtained, the posture information of the smart bracelet is obtained, and then the corresponding initial sub-antenna pattern is determined based on the posture information of the smart bracelet. Then, the initial sub-antenna pattern is rotated to obtain the corresponding rotated sub-antenna pattern, and vector orthogonal decomposition is performed on the rotated sub-antenna pattern to obtain the simulated antenna pattern. Finally, the simulated received data is obtained based on the first positioning data and the simulated antenna pattern. The initial antenna pattern includes N initial sub-antenna patterns, and each initial sub-antenna pattern corresponds to posture information of the smart bracelet. Because each initial sub-antenna pattern corresponds to posture information of the smart bracelet, roll angle information and pitch angle information of an antenna corresponding to different initial sub-antenna patterns are different. This is equivalent to the initial sub-antenna pattern being an antenna pattern that has been adjusted based on the roll angle information and the pitch angle information of the antenna. Therefore, when the initial sub-antenna pattern is being rotated based on the posture information, the initial sub-antenna pattern may be rotated based on only the azimuth angle information. Compared with rotating the initial sub-antenna pattern based on the azimuth angle information, the pitch angle information, and the roll angle information, this can improve efficiency of rotating the initial sub-antenna pattern, thereby improving efficiency of determining the simulated received data based on the simulated antenna pattern and the first positioning data.

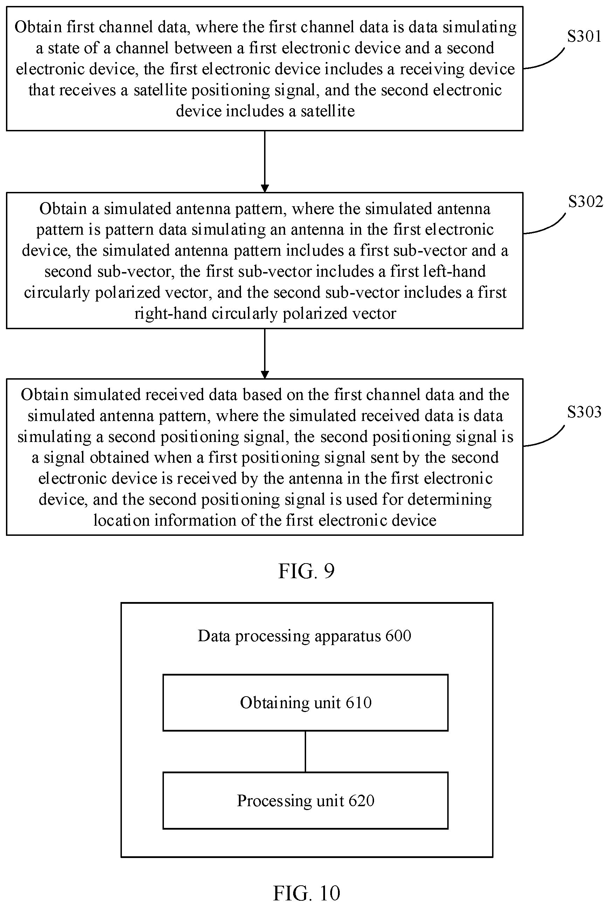

FIG. 9 is a schematic flowchart of another data processing method according to an embodiment of this application. As shown in FIG. 9, the method includes:

S301. Obtain first channel data, where the first channel data is data simulating a state of a channel between a first electronic device and a second electronic device, the first electronic device includes a receiving device that receives a satellite positioning signal, and the second electronic device includes a satellite.

S302. Obtain a simulated antenna pattern, where the simulated antenna pattern is pattern data simulating an antenna in the first electronic device, the simulated antenna pattern includes a first sub-vector and a second sub-vector, the first sub-vector includes a first left-hand circularly polarized vector, and the second sub-vector includes a first right-hand circularly polarized vector.

S303. Obtain simulated received data based on the first channel data and the simulated antenna pattern, where the simulated received data is data simulating a second positioning signal, the second positioning signal is a signal obtained when a first positioning signal sent by the second electronic device is received by the antenna in the first electronic device, and the second positioning signal is used for determining location information of the first electronic device.

According to the data processing method provided in this embodiment of this application, the first channel data is obtained, the simulated antenna pattern is obtained, and then the simulated received data is obtained based on the first channel data and the simulated antenna pattern. The first channel data is data simulating the state of the channel between the first electronic device and the second electronic device. The first electronic device includes a receiving device that receives a satellite positioning signal. The second electronic device includes a satellite. The simulated antenna pattern is pattern data simulating an antenna in the first electronic device. The simulated antenna pattern includes a first sub-vector and a second sub-vector. The first sub-vector includes a first left-hand circularly polarized vector, and the second sub-vector includes a first right-hand circularly polarized vector. The simulated received data is data simulating the second positioning signal. The second positioning signal is a signal obtained when the first positioning signal sent by the second electronic device is received by the antenna in the first electronic device, and the second positioning signal is used for determining the location information of the first electronic device. In other words, in this embodiment of this application, simulation of the second positioning signal received by the antenna in the first electronic device can be implemented by using the simulated received data obtained based on the first channel data and the simulated antenna pattern. That is, simulation of impact of an antenna parameter of the first electronic device on a received satellite positioning signal is implemented, so that accuracy of the satellite positioning signal can be evaluated based on the simulated received data obtained through simulation. Further, in a conventional method, an antenna pattern used for simulation is generally a linearly polarized antenna pattern, which is relatively different from a circularly polarized antenna pattern in an actual use process. In this embodiment of this application, the simulated antenna pattern used to determine the simulated received data is a circularly polarized antenna pattern that includes a first sub-vector and a second sub-vector, and is closer to the actually used antenna pattern. Therefore, the simulated received data obtained based on the first channel data and the simulated antenna pattern is closer to actual received data, thereby improving accuracy of the second positioning signal simulated by using the simulated received data.

It should be understood that, although the steps in the flowcharts in the foregoing embodiments are sequentially shown according to the arrows, these steps are not necessarily performed sequentially according to the sequences indicated by the arrows. Unless expressly stated in this specification, these steps are not performed in strict sequences, and these steps may be performed in other sequences. In addition, at least a part of the steps in the flowcharts may include a plurality of steps or a plurality of stages. These steps or stages are not necessarily performed and completed at the same time, but may be performed at different times. These steps or stages are not necessarily performed sequentially, but may be performed in turn or alternately with other steps or at least a part of steps or stages in the other steps.

It can be understood that, to implement the foregoing functions, the electronic device includes corresponding hardware and/or software modules for performing the functions. Algorithm steps in the examples described with reference to the embodiments disclosed in this specification can be implemented by hardware or a combination of hardware and computer software in this application. Whether a specific function is performed by hardware or hardware driven by computer software depends on a particular application and a design constraint of the technical solutions. A person skilled in the art may use different methods to implement the described functions with reference to embodiments for each particular application, but it should not be considered that the implementation goes beyond the scope of this application.

In the embodiments, the electronic device may be divided into functional modules based on the foregoing method examples. For example, each functional module may be obtained through division for each corresponding function, or two or more functions may be integrated into one module. It should be noted that division of the modules in the embodiments of this application is an example, and is merely logical function division. During actual implementation, there may be another division manner. It should be noted that the name of the module in embodiments of this application is an example, and the name of the module is not limited in actual implementation.

FIG. 10 is a schematic diagram of a structure of a data processing apparatus according to an embodiment of this application.

It should be understood that the data processing apparatus 600 may perform the data processing method shown in FIG. 5 to FIG. 9. The data processing apparatus 600 includes an obtaining unit 610 and a processing unit 620.

The obtaining unit 610 is configured to: obtain first channel data, where the first channel data is data simulating a state of a channel between a first electronic device and a second electronic device, the first electronic device includes a receiving device that receives a satellite positioning signal, and the second electronic device includes a satellite; and obtain a simulated antenna pattern, where the simulated antenna pattern is pattern data simulating an antenna in the first electronic device, the simulated antenna pattern includes a first sub-vector and a second sub-vector, the first sub-vector includes a first left-hand circularly polarized vector, and the second sub-vector includes a first right-hand circularly polarized vector

The processing unit 620 is configured to obtain simulated received data based on the first channel data and the simulated antenna pattern, where the simulated received data is data simulating a second positioning signal, the second positioning signal is a signal obtained when a first positioning signal sent by the second electronic device is received by the antenna in the first electronic device, and the second positioning signal is used for determining location information of the first electronic device. The processing unit 620 obtains the simulated received data based on the first channel data and the simulated antenna pattern, where the simulated received data is used to generate an actual positioning signal, and the actual positioning signal is a positioning signal sent by the second electronic device.

The data processing apparatus provided in this embodiment is configured to execute the data processing method in the foregoing embodiment. Technical principles and technical effects are similar, and details are not described herein again.

It should be noted that the foregoing data processing apparatus 600 is embodied in a form of a functional unit. The term "unit" herein may be implemented in a form of software and/or hardware. This is not specifically limited.

For example, the "unit" may be a software program, a hardware circuit, or a combination of both the software program and the hardware circuit for implementing the foregoing functions. The hardware circuit may include an application-specific integrated circuit (application specific integrated circuit, ASIC), an electronic circuit, a processor (for example, a shared processor, a dedicated processor, or a processor group) and a memory configured to execute one or more software or firmware programs, a combinational logic circuit, and/or another proper component that supports the described functions.

Therefore, the units in the examples described in the embodiments of this application can be implemented by electronic hardware, or a combination of computer software and electronic hardware. Whether these functions are performed by hardware or software depends on specific applications and design constraints of the technical solutions. A person skilled in the art may use different methods to implement the described functions for each specific application, but it should not be considered that such an implementation goes beyond the scope of this application.

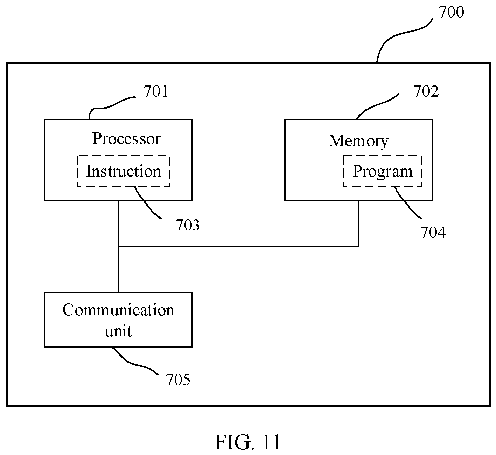

FIG. 11 is a schematic diagram of a structure of an electronic device according to this application. The dashed line in FIG. 11 indicates that the unit or the module is optional. The electronic device 700 may be configured to implement the data processing method described in the foregoing method embodiments.

The electronic device 700 includes one or more processors 701, and the one or more processors 701 may support the electronic device 700 to implement the data processing method in the foregoing method embodiment. The processor 701 may be a general-purpose processor or a dedicated processor. For example, the processor 701 may be a central processing unit (central processing unit, CPU), a digital signal processor (digital signal processor, DSP), an application-specific integrated circuit (application-specific integrated circuit, ASIC), a field programmable gate array (field programmable gate array, FPGA), or another programmable logic device, such as a discrete gate, a transistor logic device, or a discrete hardware component.

The processor 701 may be configured to control the electronic device 700, execute a software program, and process data of the software program. The electronic device 700 may further include a communication unit 705, configured to input (receive) and output (send) signals.

For example, the electronic device 700 may be a chip, the communications unit 705 may be an input circuit and/or an output circuit of the chip, or the communications unit 705 may be a communications interface of the chip, and the chip may be used as a part of a terminal device or another electronic device.

For another example, the electronic device 700 may be a terminal device, and the communications unit 705 may be a transceiver of the terminal device, or the communications unit 705 may be a transceiver circuit of the terminal device.

The electronic device 700 may include one or more memories 702. A program 704 is stored in the memory 702. The program 704 may be run by the processor 701 to generate instructions 703, so that the processor 701 executes the impedance matching method described in the foregoing method embodiment according to the instructions 703.

Optionally, the memory 702 may further store data. Optionally, the processor 701 may further read the data stored in the memory 702. The data may be stored in a same storage address as the program 704, or the data may be stored in a different storage address from the program 704.

The processor 701 and the memory 702 may be disposed separately, or may be integrated together. For example, the processor 701 and the memory 702 are integrated in a system on chip (system on chip, SOC) of the terminal device.

For example, the memory 702 may be configured to store the related program 704 of the data processing method provided in this embodiment of this application, and the processor 701 may be configured to: when performing data processing, invoke the related program 704 of the data processing method stored in the memory 702 to execute the data processing method in embodiments of this application. The method includes: obtaining first channel data, where the first channel data is data simulating a state of a channel between a first electronic device and a second electronic device, the first electronic device includes a receiving device that receives a satellite positioning signal, and the second electronic device includes a satellite; obtaining a simulated antenna pattern, where the simulated antenna pattern is pattern data simulating an antenna in the first electronic device, the simulated antenna pattern includes a first sub-vector and a second sub-vector, the first sub-vector includes a first left-hand circularly polarized vector, and the second sub-vector includes a first right-hand circularly polarized vector; and obtaining simulated received data based on the first channel data and the simulated antenna pattern, where the simulated received data is data simulating a second positioning signal, the second positioning signal is a signal that is obtained when a first positioning signal sent by the second electronic device is received by the antenna in the first electronic device, and the second positioning signal is used for determining location information of the first electronic device.

This application further provides a computer program product. When the computer program product is executed by a processor 701, the data processing method in any method embodiment of this application is implemented.

The computer program product may be stored in a memory 702, and may be, for example, a program 704. Processing processes such as preprocessing, compilation, assembling, and linking are performed on the program 704, so that the program 704 is finally converted into an executable object file that can be executed by the processor 701.

This application further provides a computer-readable storage medium. The computer-readable storage medium stores a computer program, and when the computer program is executed by a computer, the data processing method in any method embodiment of this application is implemented. The computer program may be an advanced language program, or may be an executable target program.

The computer-readable storage medium is, for example, a memory 702. The memory 702 may be a volatile memory or a non-volatile memory, or the memory 702 may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and serves as an external cache. Through example descriptions but not limitative descriptions, many forms of RAMs are available, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

In this application, "at least one" means one or more, and "a plurality of" means two or more. "At least one of the following items" or a similar expression thereof means any combination of these items, including a single item or any combination of a plurality of items. For example, at least one of a, b, or c may represent a, b, c, a-b, a-c, b-c, or a-b-c, where a, b, and c may be singular or plural.

It should be understood that in various embodiments of this application, sequence numbers of the foregoing processes do not mean a sequence of execution. The execution sequence of the processes should be determined based on functions and internal logic of the processes, and should not constitute any limitation on an implementation process of embodiments of this application.

Persons of ordinary skill in the art may be aware that the units and the algorithm steps in the examples described with reference to the embodiments disclosed in this specification can be implemented by using electronic hardware or a combination of computer software and electronic hardware. Whether these functions are performed by hardware or software depends on specific applications and design constraints of the technical solutions. A person skilled in the art may use different methods to implement the described functions for each specific application, but it should not be considered that such an implementation goes beyond the scope of this application.

It may be clearly understood by a person skilled in the art that for convenience and brevity of description, for specific working processes of the described system, apparatus, and unit, refer to the corresponding processes in the foregoing method embodiments. Details are not described herein again.

In the embodiments provided in this application, it should be understood that the disclosed apparatus and method may be implemented in other manners. For example, the apparatus embodiment described above is merely an example. For example, the unit division is merely logical function division, and there may be another division manner in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in an electrical form, a mechanical form, or another form.

The units described as separate parts may or may not be physically separated, and parts displayed as units may or may not be physical units, in other words, may be located in one place, or may be distributed on a plurality of network units. Some or all of the units may be selected based on actual requirements to achieve the objectives of the solutions in the embodiments.

In addition, the functional units in the embodiments of this application may be integrated into one processing unit, or each of the units may exist alone physically, or two or more units may be integrated into one unit.

The foregoing descriptions are merely specific implementations of this application, but are not intended to limit the protection scope of this application. Any change or replacement readily figured out by a person skilled in the art within the technical scope disclosed in this application shall fall within the protection scope of this application. Therefore, the protection scope of this application shall be subject to the protection scope of the claims.

**Claims**

**1.** A data processing method, wherein the method comprises:

obtaining first channel data, wherein the first channel data is data simulating a state of a channel between a first electronic device and a second electronic device, the first electronic device comprises a receiving device that receives a satellite positioning signal, and the second electronic device comprises the satellite;
obtaining a simulated antenna pattern, wherein the simulated antenna pattern is pattern data simulating an antenna in the first electronic device, the simulated antenna pattern comprises a first sub-vector and a second sub-vector, the first sub-vector comprises a first left-hand circularly polarized vector, and the second sub-vector comprises a first right-hand circularly polarized vector; and
obtaining simulated received data based on the first channel data and the simulated antenna pattern, wherein the simulated received data is data simulating a second positioning signal, the second positioning signal is a signal obtained when a first positioning signal sent by the second electronic device is received by the antenna in the first electronic device, and the second positioning signal is used for determining location information of the first electronic device.

**2.** The method according to claim 1, wherein the obtaining the simulated antenna pattern comprises:

obtaining posture information of the first electronic device at a current moment;
obtaining an initial antenna pattern of the first electronic device; and
correcting the initial antenna pattern based on the posture information to obtain the simulated antenna pattern.

3. The method according to claim 2, wherein the correcting the initial antenna pattern based on the posture information to obtain the simulated antenna pattern comprises:

   rotating the initial antenna pattern based on the posture information to obtain a rotated antenna pattern; and
   performing vector orthogonal decomposition on the rotated antenna pattern to obtain the simulated antenna pattern.

4. The method according to claim 3, wherein the posture information comprises azimuth angle information, the initial antenna pattern comprises N sub-initial antenna patterns, the N sub-initial antenna patterns are N antenna patterns obtained based on different postures of the first electronic device, the rotated antenna pattern comprises N sub-rotated antenna patterns, the N sub-initial antenna patterns are in one-to-one correspondence with the N sub-rotated antenna patterns, and the rotating the initial antenna pattern based on the posture information to obtain the rotated antenna pattern comprises:
   rotating each of the N sub-initial antenna patterns based on the azimuth angle information to obtain the N corresponding sub-rotated antenna patterns.

5. The method according to claim 3, wherein the posture information comprises azimuth angle information, pitch angle information, and roll angle information, and the rotating the initial antenna pattern based on the posture information to obtain the rotated antenna pattern comprises:
   rotating the initial antenna pattern based on the azimuth angle information, the pitch angle information, and the roll angle information to obtain the rotated antenna pattern.

6. The method according to any one of claims 3 to 5, wherein the initial antenna pattern comprises a second left-hand circularly polarized vector and a second right-hand circularly polarized vector, a direction of the second left-hand circularly polarized vector is the same as a direction of the first left-hand circularly polarized vector, and a direction of the second right-hand circularly polarized vector is the same as a direction of the first right-hand circularly polarized vector.

7. The method according to any one of claims 1 to 6, wherein the obtaining the first channel data comprises:

   obtaining elevation information and latitude and longitude information of the first electronic device at a current moment; and
   obtaining the first channel data based on the elevation information and the latitude and longitude information.

8. The method according to any one of claims 1 to 7, wherein the first channel data comprises one piece of simulated direct-path data and N pieces of simulated multipath data, a quantity of the first sub-vectors is N+1, a quantity of the second sub-vectors is N+1, the simulated direct-path data is corresponding to one first sub-vector and one second sub-vector, and the N pieces of simulated multipath data are respectively in one-to-one correspondence with N first sub-vectors and N second sub-vectors.

9. The method according to any one of claims 1 to 8, wherein the first electronic device is a smart bracelet.

10. An electronic device, wherein the electronic device comprises modules configured to perform the method according to any one of claims 1 to 9.

11. An electronic device, comprising:

    one or more processors;
    a memory; and
    one or more computer programs, wherein the one or more computer programs are stored in the memory, and when the computer programs are executed by the one or more processors, the electronic device is enabled to perform the method according to any one of claims 1 to 9.

12. A chip system, wherein the chip system comprises a processor, configured to invoke a computer program from a memory and run the computer program, to enable an electronic device on which the chip system is installed to perform the method according to any one of claims 1 to 9.

13. A computer-readable storage medium, comprising a computer program, wherein when the computer program is run on an electronic device, the electronic device is enabled to perform the method according to any one of claims 1 to 9.

FIG. 1

FIG. 2

Electronic device 100

Antenna 1

Antenna 2

| Mobile communication module 150 | Wireless communication module 160 |
|---|---|

| Speaker 170A | | |
|---|---|---|
| Receiver 170B | Audio module 170 | |
| Microphone 170C | | |
| Headset jack 170D | | |

| Display screen 194 |
|---|
| Camera 193 |
| Indicator 192 |
| Motor 191 |
| Key 190 |
| Internal memory 121 |
| SIM card interface 195 |
| External memory interface 120 |

Processor 110

| Sensor module 180 |
|---|
| Pressure sensor 180A |
| Gyroscope sensor 180B |
| Barometric pressure sensor 180C |
| Magnetic sensor 180D |
| Acceleration sensor 180E |
| Distance sensor 180F |
| Optical proximity sensor 180G |
| Fingerprint sensor 180H |
| Temperature sensor 180J |
| Touch sensor 180K |
| Ambient light sensor 180L |
| Bone conduction sensor 180M |

| USB interface 130 | Charging management module 140 | Power management module 141 |
|---|---|---|
| | | Battery 142 |

Charging input

FIG. 3

FIG. 4

S102

| Obtain first channel data |

Obtain pose information of a first electronic device — S101

Obtain an initial antenna pattern of an antenna in the first electronic device — S103

Rotate the initial antenna pattern based on posture information to obtain a rotated antenna pattern, where the posture information includes azimuth angle information, pitch angle information, and roll angle information — S104

Perform vector orthogonal decomposition on the rotated antenna pattern to obtain a simulated antenna pattern — S105

Obtain simulated received data based on the first channel data and the simulated antenna pattern, where the simulated received data is data simulating a second positioning signal — S106

FIG. 5

FIG. 6

(a)                              (b)                              (c)

FIG. 7

Obtain first channel data — S201

Obtain posture information of a smart bracelet — S202

Determine a corresponding initial sub-antenna pattern based on the posture information of the smart bracelet — S203

Rotate the initial sub-antenna pattern based on azimuth angle information, to obtain a corresponding rotated sub-antenna pattern — S204

Perform vector orthogonal decomposition on the rotated sub-antenna pattern to obtain a simulated antenna pattern — S205

Obtain simulated received data based on the first channel data and the simulated antenna pattern, where the simulated received data is data simulating a second positioning signal — S206

FIG. 8

Obtain first channel data, where the first channel data is data simulating a state of a channel between a first electronic device and a second electronic device, the first electronic device includes a receiving device that receives a satellite positioning signal, and the second electronic device includes a satellite

S301

Obtain a simulated antenna pattern, where the simulated antenna pattern is pattern data simulating an antenna in the first electronic device, the simulated antenna pattern includes a first sub-vector and a second sub-vector, the first sub-vector includes a first left-hand circularly polarized vector, and the second sub-vector includes a first right-hand circularly polarized vector

S302

Obtain simulated received data based on the first channel data and the simulated antenna pattern, where the simulated received data is data simulating a second positioning signal, the second positioning signal is a signal obtained when a first positioning signal sent by the second electronic device is received by the antenna in the first electronic device, and the second positioning signal is used for determining location information of the first electronic device

S303

FIG. 9

Data processing apparatus 600

Obtaining unit 610

Processing unit 620

FIG. 10

700

701 702

| Processor |
| --- |
| Instruction |

703

| Memory |
| --- |
| Program |

704

| Communication unit |
| --- |

705

FIG. 11

## INTERNATIONAL SEARCH REPORT

| International application No. |
|---|
| **PCT/CN2025/095242** |

### A. CLASSIFICATION OF SUBJECT MATTER

G01S 19/23(2010.01)i; H01Q 1/27(2006.01)i

According to International Patent Classification (IPC) or to both national classification and IPC

### B. FIELDS SEARCHED

Minimum documentation searched (classification system followed by classification symbols)

IPC: G01S, H01Q

Documentation searched other than minimum documentation to the extent that such documents are included in the fields searched

Electronic data base consulted during the international search (name of data base and, where practicable, search terms used)

CNTXT, ENTXTC, WPABSC, DWPI: 荣耀终端股份有限公司, 卫星, 定位, 天线, 辐射, 方向图, 信道, 圆极化, 左旋, 右旋, 模拟, 仿真, satellite, positioning, antenna, radiation, pattern, channel, circularly w polarized, left-handed, right-handed, simulat+

### C. DOCUMENTS CONSIDERED TO BE RELEVANT

| Category* | Citation of document, with indication, where appropriate, of the relevant passages | Relevant to claim No. |
|---|---|---|
| A | CN 115084867 A (HONOR DEVICE CO., LTD.) 20 September 2022 (2022-09-20) description, paragraphs [0003]-[0052], and figures 1-5 | 1-13 |
| A | CN 103384835 A (HUAWEI TECHNOLOGIES CO., LTD.) 06 November 2013 (2013-11-06) entire document | 1-13 |
| A | CN 113435069 A (HUNAN SATELLITE NAVIGATION INFORMATION TECHNOLOGY CO., LTD.) 24 September 2021 (2021-09-24) entire document | 1-13 |
| A | CN 115290991 A (HONOR DEVICE CO., LTD.) 04 November 2022 (2022-11-04) entire document | 1-13 |
| A | CN 117134097 A (ANHUI HUAMI INFORMATION TECHNOLOGY CO., LTD.) 28 November 2023 (2023-11-28) entire document | 1-13 |
| A | KR 20240070350 A (SAMSUNG ELECTRONICS CO., LTD.) 21 May 2024 (2024-05-21) entire document | 1-13 |

☐ Further documents are listed in the continuation of Box C.    ☑ See patent family annex.

| | |
|---|---|
| *   Special categories of cited documents:<br>"A"   document defining the general state of the art which is not considered to be of particular relevance<br>"D"   document cited by the applicant in the international application<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **11 August 2025** | **20 August 2025** |

| Name and mailing address of the ISA/CN | Authorized officer |
|---|---|
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2025/095242**

| Patent document cited in search report | | | Publication date (day/month/year) | Patent family member(s) | | | Publication date (day/month/year) |
|---|---|---|---|---|---|---|---|
| CN | 115084867 | A | 20 September 2022 | WO | 2024016771 | A1 | 25 January 2024 |
| | | | | EP | 4333210 | A1 | 06 March 2024 |
| | | | | US | 2025087884 | A1 | 13 March 2025 |
| CN | 103384835 | A | 06 November 2013 | WO | 2014101177 | A1 | 03 July 2014 |
| CN | 113435069 | A | 24 September 2021 | None | | | |
| CN | 115290991 | A | 04 November 2022 | None | | | |
| CN | 117134097 | A | 28 November 2023 | None | | | |
| KR | 20240070350 | A | 21 May 2024 | WO | 2024106919 | A1 | 23 May 2024 |

Form PCT/ISA/210 (patent family annex) (July 2022)

**REFERENCES CITED IN THE DESCRIPTION**

**Patent documents cited in the description**

- CN 202410737618X